# EUROPÄISCHE PATENTSCHRIFT

(11) **EP 4 223 088 B1**
(45) Veröffentlichungstag und Bekanntmachung des Hinweises auf die Patenterteilung: **28.08.2024**
(21) Anmeldenummer: 22790493.5
(22) Anmeldetag: 21.09.2022
(51) Int. Cl.: H05K 5/06, H01R 13/52

(54) **ELEKTRONISCHES GERÄT UND ENTSPRECHENDE BAUREIHE**
ELECTRONIC DEVICE AND CORRESPONDING PRODUCT SERIES
DISPOSITIF ÉLECTRONIQUE ET SÉRIE DE PRODUITS CORRESPONDANTE

(30) Priorität: 03.12.2021 DE 102021131953
(43) Veröffentlichungstag der Anmeldung: 09.08.2023
(73) Patentinhaber: AUMA Riester GmbH & Co. KG, 79379 Müllheim (DE)
(72) Erfinder: STENZEL, Rüdiger, 57271 Hilchenbach (DE)
(74) Vertreter: Mertzlufft-Paufler, Cornelius
(86) Internationale Anmeldenummer: PCT/EP2022/076226
(87) Internationale Veröffentlichungsnummer: WO 2023/099056

(56) Entgegenhaltungen:
- DE-A1- 10 058 107
- DE-A1- 102019 107 721
- DE-U1- 202015 008 215
- DE-U1- 202015 008 215

## Beschreibung

Die Erfindung betrifft ein elektronisches Gerät mit einem Gehäuse, dass eine Öffnung aufweist, in welcher ein Steckerteil einer elektrischen Steckverbindung eingesetzt ist, wobei die Öffnung durch einen topfförmigen Deckel, der ein Gegensteckerteil der elektrischen Verbindung aufnimmt, verschließbar ist, wobei das Steckerteil auf seiner Rückseite vergossen ist. Ein derartiges elektronisches Gerät findet in der Praxis vielfach Anwendung.

Die Erfindung betrifft weiter eine Baureihe mit zwei Varianten. Eine derartige Baureihe ist bekannt.

Aus der DE 20 2015 008 215 U1 ist eine Kontaktierungsvorrichtung bekannt, die eine erste Anschlussseite und eine zweite Anschlussseite hat, wobei an der ersten Anschlussseite wenigstens ein erstes Anschlussmittel und an der zweiten Anschlussseite wenigstens ein zweites Anschlussmittel ausgebildet sind, wobei das wenigstens eine erste Anschlussmittel mit dem wenigstens einen zweiten Anschlussmittel elektrisch verbunden ist.

Aus der DE 10 2019 107 721 A1 ist ein Stellantrieb bekannt, welcher ein Gehäuse hat, in welcher eine Elektronik angeordnet ist, und wobei die Elektronik an einem in das Gehäuse herausnehmbar eingesetzten Träger angeordnet ist und über wenigstens eine elektrische Verbindung an einen Steckerteil angeschlossen ist, wobei das Steckerteil mit einem an dem Gehäuse befestigten Gegensteckerteil lösbar verbunden ist.

Aus der DE 100 58 107 A1 ist ein Elektrogerät, insbesondere ein Armaturen-Stellantrieb mit einem explosionsgeschützten Gehäuse, bekannt, wobei eine dichte Trennwand mit abgedichteten Durchführungen für elektrische Leitungen zwischen einem Gehäuse-Innenraum und einem äußeren Anschlussraum vorgesehen ist und wobei sich im äußeren Anschlussraum Elektroanschlüsse mit Klemmanschlüssen für Zuleitungen befinden.

Derartige Geräte können beispielsweise als Stellantriebe oder als Steuerungseinrichtung für einen Stellantrieb realisiert sein, wobei eine elektrische Kontaktierung über ein Kabel in den Deckel geführt wird und dort an ein Gegensteckerteil zu dem Steckerteil angeschlossen wird, so dass der Deckel die Steckverbindung oder elektrische Kontaktierung zum Gegensteckerteil und dem Steckerteil herstellt.

Der Erfindung liegt die Aufgabe zugrunde, die Betriebseigenschaften und die Verbundeigenschaften von elektronischen Geräten zu verbessern. Der Erfindung liegt ferner die Aufgabe zugrunde, eine in sich dichte Anordnung bereitzustellen, welche abdichtend gegen externe Einflüsse wie Wasser oder Staub wirkt und einen guten Korrosionsschutz bereitstellt.

Zur Lösung der gestellten Aufgabe schlägt die Erfindung die Merkmale von Anspruch 1 vor. Insbesondere wird somit erfindungsgemäß bei einem elektronischen Gerät der eingangs beschriebenen Art zur Lösung der genannten Aufgabe vorgeschlagen, dass das Gehäuse mit dem Deckel dichtend verbunden ist. Somit kann eine in sich dichtende Anordnung bereitgestellt werden.

Nachfolgend werden vorteilhafte Ausgestaltungen der Erfindung beschrieben, die allein oder in Kombination mit den Merkmalen anderer Ausgestaltungen optional zusammen mit den Merkmalen nach Anspruch 1 kombiniert werden können.

Es ist darauf hinzuweisen, dass die in den abhängigen Ansprüchen einzeln aufgeführten Merkmale in beliebiger technologisch sinnvoller Weise miteinander kombiniert werden können und weitere Ausgestaltungen der Erfindung definieren. Darüber hinaus werden die in den Ansprüchen angegebenen Merkmale in der Beschreibung näher präzisiert und erläutert, wobei weitere bevorzugte Ausgestaltungen der Erfindung dargestellt werden.

Bei einer vorteilhaften Ausgestaltung kann vorgesehen sein, dass das Steckerteil und das Gegensteckerteil lösbar verbunden sind. Somit kann das elektronische Gerät einfach und zeitsparend zusammengebaut oder montiert werden.

Bei einer vorteilhaften Ausgestaltung kann vorgesehen sein, dass der Deckel einen Dichtring aufweist, welcher einen größeren Durchmesser hat als das Gegensteckerteil. Somit kann eine Dichtung gegen äußere Einflüsse wie Wind, Wasser oder Staub bereitgestellt werden. Bevorzugt ist der Dichtring als Deckeldichtring ausgeprägt.

Bei einer vorteilhaften Ausgestaltung kann vorgesehen sein, dass der Dichtring einen größeren Durchmesser hat als das Steckerteil. Somit kann eine Dichtung gegen äußere Einflüsse wie Wind, Wasser oder Staub bereitgestellt werden.

Bei einer vorteilhaften Ausgestaltung kann vorgesehen sein, dass das Steckerteil innenseitig mit dem Gehäuse vorzugsweise direkt verbunden ist. Alternativ oder zusätzlich kann das Steckerteil in einer Einsetzrichtung des Steckerteils beabstandet zu einer Dichtfläche des Gehäuses zum Deckel verbunden sein. Somit kann eine leicht montierbare Anordnung bereitgestellt werden.

Bevorzugt weist der Deckel eine vorzugsweise kreisrunde Öffnung auf, durch welche Kabel und eine elektrische Steckverbindung geführt werden können. Die Kabel und die elektrische Steckverbindung können einen Stellantrieb mit Energie versorgen. Alternativ oder zusätzlich kann das Kabel Einstellparameter wie Position, Geschwindigkeit oder Drehmoment an den Stellantrieb übermitteln.

Bei einer vorteilhaften Ausgestaltung kann vorgesehen sein, dass das Steckerteil mit einem Vergussteil formschlüssig verbunden ist. Alternativ oder zusätzlich kann das Steckerteil mit dem Vergussteil kraftschlüssig verbunden sein. Somit kann eine platzsparende und leicht montierbare Anordnung bereitgestellt werden.

Bei einer vorteilhaften Ausgestaltung kann vorgesehen sein, dass das Vergussteil mit einem Gegenvergussteil verbunden ist. Somit kann eine gut dichtende Anordnung bereitgestellt werden.

Bevorzugt ist das Vergussteil mit dem Gegenvergussteil stoffschlüssig miteinander verbunden, beispielsweise über eine Klebeverbindung.

Bei einer vorteilhaften Ausgestaltung kann vorgesehen sein, dass das Gegenvergussteil über einen Kabeldurchlass verfügt, welcher mittig zum Gehäuse angeordnet ist. Somit kann Energie für den Stellantrieb bereitgestellt werden oder Parameter für den Stellantrieb eingestellt werden.

Bei einer vorteilhaften Ausgestaltung kann vorgesehen sein, dass eine Vergussdose ausgeprägt ist. Bevorzugt besteht die Vergussdose aus einem Kunststoff oder einem Metall. Somit kann die Vergussmasse effizient und platzsparend eingefüllt werden.

Bei einer vorteilhaften Ausgestaltung kann vorgesehen sein, dass die Vergussdose das Gegenvergussteil, das Vergussteil und zusätzlich oder alternativ das Steckerteil kontaktiert. Somit kann eine platzsparende Anordnung erreicht werden.

Bei einer vorteilhaften Ausgestaltung kann vorgesehen sein, dass die Vergussdose durch eine Vergussmasse am Steckerteil gehalten ist. Die Vergussmasse umfasst das Vergussteil und zusätzlich oder alternativ das Gegenvergussteil. Somit kann eine in sich dichtende Anordnung zur Verfügung gestellt werden.

Bei einer vorteilhaften Ausgestaltung kann vorgesehen sein, dass der Durchmesser der Vergussdose kleiner ist als der Durchmesser des Steckerteils. Somit kann eine platzsparende Anordnung bereitgestellt werden.

Bei einer vorteilhaften Ausgestaltung kann vorgesehen sein, dass das Steckerteil mittels Befestigungselementen, insbesondere Schraubverbindungen, mit dem Gehäuse verbunden ist. Somit kann eine einfache und kostengünstige Verbindung erreicht werden.

Bei einer vorteilhaften Ausgestaltung kann vorgesehen sein, dass ein Dichtring, vorzugsweise ein Vergussdosendichtring, zwischen der Vergussdose und dem Gehäuse ausgeprägt ist. Somit kann eine Dichtung zwischen einzelnen Teilen innerhalb des Gehäuses erreicht werden.

Bei einer vorteilhaften Ausgestaltung kann vorgesehen sein, dass der Durchmesser des Dichtrings, vorzugsweise des Vergussdosendichtrings, kleiner ist als ein maximaler Durchmesser der Vergussdose. Somit kann eine passgenaue Anordnung bereitgestellt werden.

Bei einer vorteilhaften Ausgestaltung kann vorgesehen sein, dass der Kabeldurchlass durch ein Loch in der Vergussdose führt. Bevorzugt ist das Loch kreisrund. Somit kann eine passgenaue und platzsparende Anordnung bereitgestellt werden.

Bei einer vorteilhaften Ausgestaltung kann vorgesehen sein, dass ein Befestigungsraum zwischen dem Steckerteil und dem Gegensteckerteil ausgeprägt ist. Somit kann eine mechanisch stabile Anordnung erreicht werden.

Bei einer vorteilhaften Ausgestaltung kann vorgesehen sein, dass die Vergussdose an einem Ende direkt in den Befestigungsraum ragt. Somit kann eine mechanisch stabile Anordnung erreicht werden.

Bei einer vorteilhaften Ausgestaltung kann vorgesehen sein, dass Befestigungselemente in den Befestigungsraum ragen. Bevorzugt sind die Befestigungselemente Schrauben. Somit kann eine mechanisch stabile Verbindung bereitgestellt werden.

Vorzugsweise verbinden die Befestigungselemente das Gegensteckerteil mit dem Deckel beziehungsweise das Steckerteil mit dem Gehäuse. Durch die Verwendung von Befestigungselementen kann die Anordnung leicht im Deckel und im Gehäuse montiert und demontiert werden.

Bei einer vorteilhaften Ausgestaltung kann vorgesehen sein, dass das Gegensteckerteil mittels Befestigungselementen mit dem Deckel verbunden ist. Somit kann eine leicht montierbare Anordnung bereitgestellt werden.

Bei einer vorteilhaften Ausgestaltung kann vorgesehen sein, dass das Steckerteil mittels Befestigungselementen mit dem Gehäuse verbunden ist. Somit kann eine leicht montierbare Anordnung bereitgestellt werden.

Bei einer vorteilhaften Ausgestaltung kann vorgesehen sein, dass das Steckerteil über Öffnungen verfügt, in welche Stifte einsetzbar sind. Die Stifte sind elektrisch ausgeprägt und umfassen einen Stiftkörper und elektrische Leitungen. Die Stifte sind dichtend in den Öffnungen verbaut, sodass keine Feuchtigkeit durch sie dringen kann. Somit wird eine Kontrolleinheit für den Stellantrieb bereitgestellt.

Bei einer vorteilhaften Ausgestaltung kann vorgesehen sein, dass das Vergussteil stoffschlüssig und alternativ oder zusätzlich formschlüssig mit der Vergussdose verbunden ist. Somit kann eine passgenaue und kompakte Anordnung bereitgestellt werden.

Der Stoffschluss kann über eine Klebeverbindung erreicht werden.

Zur Lösung der genannten Aufgabe sind erfindungsgemäß die Merkmale des auf eine Baureihe gerichteten nebengeordneten Anspruchs vorgesehen. Insbesondere wird zur Lösung der genannten Aufgabe somit erfindungsgemäß bei einer Baureihe der eingangs beschriebenen Art vorgeschlagen, dass in einer ersten Variante ein elektronisches Gerät nach den vorher genannten Merkmalen ausgebildet ist, und in einer zweiten Variante, bei der ein Steckerteil unvergossen ausgebildet ist, wobei die erste Variante und die zweite Variante zumindest übereinstimmende Deckel und Gehäuse haben. Somit kann eine dichte Anordnung bereitgestellt werden.

Bei einer vorteilhaften Ausgestaltung der Baureihe kann vorgesehen sein, dass die erste Variante und die zweite Variante übereinstimmende Steckerteile und zusätzlich oder alternativ übereinstimmende Gegensteckerteile haben und zusätzlich oder alternativ die zweite Variante keine Vergussdose hat. Somit können konstruktive Alternativen bereitgestellt werden.

Die Erfindung wird nun anhand eines Ausführungsbeispiels näher beschrieben, ist jedoch nicht auf dieses Ausführungsbeispiel beschränkt. Weitere Ausführungsbeispiele ergeben sich durch Kombination der Merkmale einzelner oder mehrerer Schutzansprüche untereinander und/oder mit einzelnen oder mehreren Merkmalen des Ausführungsbeispiels.

Es zeigt:
- Fig. 1: ein elektronisches Gerät ohne Vergussmasse in Schnittdarstellung
- Fig. 2: ein elektronisches Gerät mit Vergussmasse in Schnittdarstellung

Bei der nachfolgenden Beschreibung verschiedener Ausführungsbeispiele der Erfindung erhalten in ihrer Funktion übereinstimmende Elemente auch bei abweichender Gestaltung oder Formgebung übereinstimmende Bezugszahlen.

Zur besseren Übersicht sind in den Figuren nicht alle Bezugszeichen gesetzt, obwohl die Elemente sehr wohl in den Figuren vorhanden sein können. Gleiche Bezugszeichen bezeichnen jedoch funktionell und/oder konstruktiv gleiche Bauteile und Funktionseinheiten.

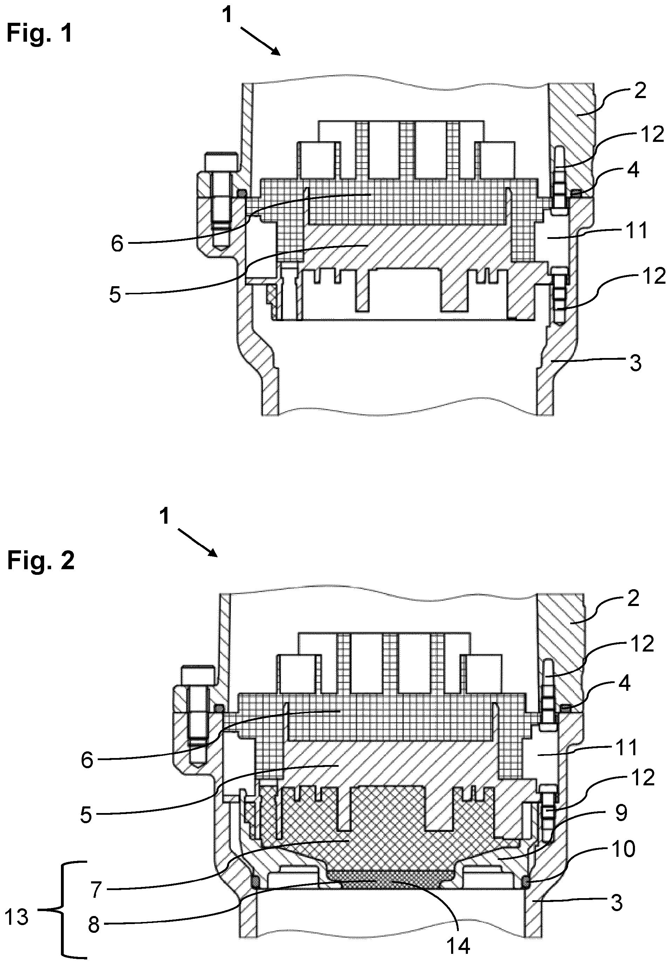

Fig. 1 zeigt ein elektronisches Gerät 1 ohne Vergussmasse 13 in Schnittdarstellung.

Das elektronische Gerät 1 umfasst einen topfförmigen Deckel 2 und ein Gehäuse 3. Die zwei Teile sind über als Schraubverbindungen ausgeprägte Befestigungselemente miteinander verbunden wobei ein Dichtring 4 die Fläche zwischen dem Deckel 2 und dem Gehäuse 3 abdichtet.

Das elektronische Gerät umfasst des Weiteren ein Steckerteil 5 und ein Gegensteckerteil 6, wobei die beiden Teile form- und/oder kraftschlüssig miteinander verbunden sind.

Das Gegensteckerteil 6 ist mit einem Befestigungselement mit dem Deckel 2 verbunden. Das Steckerteil 5 ist mit einem Befestigungselement mit dem Gehäuse 3 verbunden.

Das Steckerteil 5 weist Öffnungen (nicht dargestellt) auf, in welche elektrische Stifte einsetzbar sind. Die elektrischen Stifte (nicht dargestellt) weisen in an sich bekannter Weise einen Stiftkörper und elektrische Leitungen auf. Die elektrischen Leitungen leiten Energie zum Stellantrieb oder umfassen einen Datentransfer, mit welchem Parameter für den Stellantrieb eingestellt werden können. Mögliche Parameter für den Stellantrieb können beispielsweise eine Position, eine Schließgeschwindigkeit oder ein Drehmoment sein.

Fig. 2 zeigt eine elektronisches Gerät 1 mit Vergussmasse 13 in Schnittdarstellung.

Das elektronische Gerät 1 umfasst einen topfförmigen Deckel 2 und ein Gehäuse 3. Die zwei Teile sind über als Schraubverbindungen ausgeprägte Befestigungselemente miteinander verbunden wobei ein Dichtring 4 die Fläche zwischen dem Deckel 2 und dem Gehäuse 3 abdichtet.

Das elektronische Gerät umfasst des Weiteren ein Steckerteil 5 und ein Gegensteckerteil 6. Die beiden Teile sind form- und/oder kraftschlüssig miteinander verbunden.

Das Steckerteil verfügt über Öffnungen (nicht dargestellt), welche elektrische Stifte (nicht dargestellt) aufnehmen können. Die elektrischen Stifte umfassen einen Stiftkörper und darin hindurchgehend elektrische Leitungen.

Das Gegensteckerteil 6 ist mit einem Befestigungselement mit dem Deckel 2 verbunden. Das Stiftteil 5 ist mit einem Befestigungselement 12 mit dem Gehäuse 3 verbunden.

Zwischen dem Steckerteil 5 und dem Gegensteckerteil 6 ist ein Befestigungsraum 11 ausgeprägt.

Das elektronische Gerät 1 umfasst des Weiteren ein Vergussteil 7 und ein Gegenvergussteil 8 und eine Vergussdose 9. Die Vergussdose 9 kontaktiert das Steckerteil 5, das Vergussteil 7 und das Gegenvergussteil 8. Ein Dichtring 10 ist zwischen der Vergussdose 9 und dem Gehäuse 3 ausgeprägt, welcher den Innenraum des Gehäuses vor eindringender Feuchtigkeit oder Staubbelastung schützt.

Die Vergussdose 9 hat ein vorzugsweise kreisrundes Loch, in welches ein Kabeldurchlass 14 mittig zum Gehäuse 3 ausgeprägt ist.

Das Steckerteil 5 und das Gegensteckerteil 6 sind lösbar miteinander verbunden.

Der Deckel 2 hat einen Dichtring 4, welcher einen größeren Durchmesser hat als das Gegensteckerteil 6 und als das Steckerteil 5.

Das Steckerteil 5 ist mit dem Vergussteil 7 formschlüssig und zusätzlich oder alternativ kraftschlüssig verbunden.

Das Vergussteil 7 ist mit dem Gegenvergussteil 8 verbunden.

Das Gegenvergussteil 8 ist in einem Loch der Vergussdose 9 angeordnet.

Die Vergussdose 9 kontaktiert das Vergussteil 7 und/oder das Steckerteil 5. Die Vergussdose 9 wird durch eine Vergussmasse 13 am Steckerteil 5 gehalten. Die Vergussmasse 13 ist als Vergussteil 7 und als Gegenvergussteil 8 ausgeprägt. Der Durchmesser der Vergussdose 9 ist kleiner als der Durchmesser des Steckerteils 5.

Das Steckerteil 5 ist mittels Befestigungselementen 12 mit dem Gehäuse 3 verbunden. Vorzugsweise sind diese Befestigungselemente 12 Schrauben.

Ein Dichtring 10 ist zwischen der Vergussdose 9 und dem Gehäuse 3 ausgeprägt. Der Durchmesser des Dichtrings 10 ist kleiner als ein maximaler Durchmesser der Vergussdose 9. Ein Kabeldurchlass 14 führt durch ein Loch in der Vergussdose 9.

Ein Befestigungsraum 11 ist zwischen dem Steckerteil 5 und dem Gegensteckerteil 6 ausgeprägt. Die Vergussdose 9 ragt an einem Ende direkt in den Befestigungsraum 11. Befestigungselemente 12, insbesondere Schrauben, ragen ebenfalls in den Befestigungsraum 11.

Das Gegensteckerteil 6 ist mittels Befestigungselementen 12 mit dem Deckel 2 verbunden. Das Steckerteil 5 ist mittels Befestigungselementen 12 mit dem Gehäuse 3 verbunden.

Das Steckerteil 5 verfügt über Öffnungen (nicht dargestellt), in welche elektrische Stifte einsetzbar sind.

Das Vergussteil 7 ist stoffschlüssig und/oder formschlüssig mit der Vergussdose 9 verbunden.

Bei einem elektronischen Gerät mit einem Gehäuse, dass eine Öffnung aufweist, in welcher ein Steckerteil einer elektrischen Steckverbindung eingesetzt ist, wobei die Öffnung durch einen topfförmigen Deckel, der ein Gegensteckerteil der elektrischen Steckverbindung aufnimmt, verschließbar ist, wobei das Steckerteil auf seiner Rückseite vergossen ist, wird vorgeschlagen, dass das Gehäuse mit dem Deckel dichtend verbunden ist.

### Bezugszeichenliste

- 1: elektronisches Gerät
- 2: Deckel
- 3: Gehäuse
- 4: Dichtring
- 5: Steckerteil
- 6: Gegensteckerteil
- 7: Vergussteil
- 8: Gegenvergussteil
- 9: Vergussdose
- 10: (anderer) Dichtring
- 11: Befestigungsraum
- 12: Befestigungselement
- 13: Vergussmasse
- 14: Kabeldurchlass

## Patentansprüche

1. Elektronisches Gerät (1), insbesondere Stellantrieb, mit einem Gehäuse (3), das eine Öffnung aufweist, in die ein Steckerteil (5) einer elektrischen Steckverbindung eingesetzt ist, **dadurch gekennzeichnet, dass** die Öffnung durch einen topfförmigen Deckel (2), der ein Gegensteckerteil (6) der elektrischen Steckverbindung aufnimmt, verschließbar ist, wobei das Steckerteil (5) auf seiner Rückseite vergossen ist, und das Gehäuse (3) mit dem Deckel (2) dichtend verbunden ist.

2. Elektronisches Gerät (1) nach Anspruch 1, **dadurch gekennzeichnet, dass** das Steckerteil (5) und das Gegensteckerteil (6) lösbar verbunden sind.

3. Elektronisches Gerät (1) nach einem der vorgehenden Ansprüche, **dadurch gekennzeichnet, dass** der Deckel (2) einen Dichtring (4), insbesondere Deckeldichtring, aufweist, welcher einen größeren Durchmesser hat als das Gegensteckerteil (6).

4. Elektronisches Gerät (1) nach einem der vorgehenden Ansprüche, **dadurch gekennzeichnet, dass** der Dichtring (4), insbesondere Deckeldichtring, einen größeren Durchmesser hat als das Steckerteil (5).

5. Elektronisches Gerät (1) nach einem der vorgehenden Ansprüche, **dadurch gekennzeichnet, dass** das Steckerteil (5) innenseitig mit dem Gehäuse vorzugsweise direkt und/oder in einer Einsetzrichtung des Steckerteils (5) beabstandet zu einer Dichtfläche des Gehäuses (3) zum Deckel (2) verbunden ist.

6. Elektronisches Gerät (1) nach einem der vorgehenden Ansprüche, **dadurch gekennzeichnet, dass** das Steckerteil (5) mit einem Vergussteil (7) formschlüssig und/oder kraftschlüssig verbunden ist.

7. Elektronisches Gerät (1) nach einem der vorgehenden Ansprüche, **dadurch gekennzeichnet, dass** das Vergussteil (7) mit einem Gegenvergussteil (8) verbunden ist.

8. Elektronisches Gerät (1) nach einem der vorgehenden Ansprüche, **dadurch gekennzeichnet, dass** das Gegenvergussteil (8) über einen Kabeldurchlass (14) verfügt, welcher vorzugsweise mittig zum Gehäuse (3) angeordnet ist.

9. Elektronisches Gerät (1) nach einem der vorgehenden Ansprüche, **dadurch gekennzeichnet, dass** eine Vergussdose (9) ausgeprägt ist.

10. Elektronisches Gerät (1) nach einem der vorgehenden Ansprüche, **dadurch gekennzeichnet, dass** die Vergussdose (9) das Gegenvergussteil (8), das Vergussteil (7) und/oder das Steckerteil (5) kontaktiert.

11. Elektronisches Gerät (1) nach einem der vorgehenden Ansprüche, **dadurch gekennzeichnet, dass** die Vergussdose (9) durch eine Vergussmasse (13) am Steckerteil (5) gehalten ist.

12. Elektronisches Gerät (1) nach einem der vorgehenden Ansprüche, **dadurch gekennzeichnet, dass** der Durchmesser der Vergussdose (9) kleiner ist als der Durchmesser des Steckerteils (5).

13. Elektronisches Gerät (1) nach einem der vorgehenden Ansprüche, **dadurch gekennzeichnet, dass** das Steckerteil (5) mittels Befestigungselementen (12), insbesondere Schraubverbindungen, mit dem Gehäuse (3) verbunden ist.

14. Elektronisches Gerät (1) nach einem der vorgehenden Ansprüche, **dadurch gekennzeichnet, dass** ein Dichtring (10), insbesondere Vergussdosendichtring, zwischen der Vergussdose (9) und dem Gehäuse (3) ausgeprägt ist.

15. Elektronisches Gerät (1) nach einem der vorgehenden Ansprüche, **dadurch gekennzeichnet, dass** der Durchmesser des Dichtrings (10), insbesondere des Vergussdosendichtrings, kleiner ist als ein maximaler Durchmesser der Vergussdose (9) .

16. Elektronisches Gerät (1) nach einem der vorgehenden Ansprüche, **dadurch gekennzeichnet, dass** der Kabeldurchlass (14) durch ein, insbesondere kreisrundes, Loch in der Vergussdose (9) führt.

17. Elektronisches Gerät (1) nach einem der vorgehenden Ansprüche, **dadurch gekennzeichnet, dass** ein Befestigungsraum (11) zwischen dem Steckerteil (5) und dem Gegensteckerteil (6) ausgeprägt ist.

18. Elektronisches Gerät (1) nach einem der vorgehenden Ansprüche, **dadurch gekennzeichnet, dass** die Vergussdose (9) an einem Ende direkt in den Befestigungsraum (11) ragt.

19. Elektronisches Gerät (1) nach einem der vorgehenden Ansprüche, **dadurch gekennzeichnet, dass** Befestigungselemente (12), insbesondere Schrauben, in den Befestigungsraum (11) ragen.

20. Elektronisches Gerät (1) nach einem der vorgehenden Ansprüche, **dadurch gekennzeichnet, dass** das Gegensteckerteil (6) mittels Befestigungselementen (12), insbesondere Schrauben, mit dem Deckel (2) verbunden ist.

21. Elektronisches Gerät (1) nach einem der vorgehenden Ansprüche, **dadurch gekennzeichnet, dass** das Steckerteil (5) mittels Befestigungselementen (12), insbesondere Schrauben, mit dem Gehäuse (3) verbunden ist.

22. Elektronisches Gerät (1) nach einem der vorgehenden Ansprüche, **dadurch gekennzeichnet, dass** das Steckerteil (5) über Öffnungen verfügt, in welche Stifte einsetzbar sind.

23. Elektronisches Gerät (1) nach einem der vorgehenden Ansprüche, **dadurch gekennzeichnet, dass** das Vergussteil (7) stoffschlüssig und/oder formschlüssig mit der Vergussdose (9) verbunden ist.

24. Baureihe eines elektronischen Gerätes (1), mit einer ersten Variante, bei der das elektronische Gerät (1) nach den Ansprüchen 1 bis 23 ausgebildet ist, und einer zweiten Variante, bei der ein Steckerteil (5) unvergossen ausgebildet ist, **dadurch gekennzeichnet, dass** die erste Variante und die zweite Variante zumindest übereinstimmende Deckel (2) und Gehäuse (3) haben.

25. Baureihe nach dem vorangehenden Anspruch, **dadurch gekennzeichnet, dass** die erste Variante und die zweite Variante übereinstimmende Steckerteile (5) und/oder übereinstimmende Gegensteckerteile (6) haben und/oder dass die zweite Variante keine Vergussdose (9) hat.

## Claims

1. Electronic device (1), in particular an actuator, having a housing (3) which has an opening into which a plug part (5) of an electrical plug connection is inserted, **characterized in that** the opening can be closed by a pot-shaped cover (2) which accommodates a mating plug part (6) of the electrical plug connection, wherein the plug part (5) is encapsulated on its rear side, and the housing (3) is connected to the cover (2) in a sealing manner.

2. Electronic device (1) according to claim 1, **characterized in that** the plug part (5) and the mating plug part (6) are detachably connected.

3. Electronic device (1) according to one of the preceding claims, **characterized in that** the cover (2) has a sealing ring (4), in particular a cover sealing ring, which has a larger diameter than the mating plug part (6).

4. Electronic device (1) according to one of the preceding claims, **characterized in that** the sealing ring (4), in particular the cover sealing ring, has a larger diameter than the plug part (5).

5. Electronic device (1) according to one of the preceding claims, **characterized in that** the plug part (5) is connected on the inside to the housing, preferably directly and/or in an insertion direction of the plug part (5) at a distance from a sealing surface of the housing (3) to the cover (2).

6. Electronic device (1) according to one of the preceding claims, **characterized in that** the plug part (5) is connected to a potting part (7) in a form-fit and/or force-fit manner.

7. Electronic device (1) according to one of the preceding claims, **characterized in that** the potting part (7) is connected to a mating potting part (8).

8. Electronic device (1) according to one of the preceding claims, **characterized in that** the mating potting part (8) has a cable passage (14), which is preferably arranged centrally with respect to the housing (3).

9. Electronic device (1) according to one of the preceding claims, **characterized in that** a potting box (9) is formed.

10. Electronic device (1) according to one of the preceding claims, **characterized in that** the potting box (9) contacts the mating potting part (8), the potting part (7) and/or the plug part (5).

11. Electronic device (1) according to one of the preceding claims, **characterized in that** the potting box (9) is held on the plug part (5) by a potting compound (13).

12. Electronic device (1) according to one of the preceding claims, **characterized in that** the diameter of the potting box (9) is smaller than the diameter of the plug part (5).

13. Electronic device (1) according to one of the preceding claims, **characterized in that** the plug part (5) is connected to the housing by means of fastening elements (12), in particular screw connections.

14. Electronic device (1) according to one of the preceding claims, **characterized in that** a sealing ring (10), in particular a potting box sealing ring, is formed between the potting box (9) and the housing (3).

15. Electronic device (1) according to one of the preceding claims, **characterized in that** the diameter of the sealing ring (10), in particular of the potting box sealing ring, is smaller than a maximum diameter of the potting box (9).

16. Electronic device (1) according to one of the preceding claims, **characterized in that** the cable passage (14) leads through a hole, in particular a circular hole, in the potting box (9).

17. Electronic device (1) according to one of the preceding claims, **characterized in that** a fastening space (11) is formed between the plug part (5) and the mating plug part (6).

18. Electronic device (1) according to one of the preceding claims, **characterized in that** the potting box (9) projects at one end directly into the fastening space (11).

19. Electronic device (1) according to one of the preceding claims, **characterized in that** fastening elements (12), in particular screws, project into the fastening space (11).

20. Electronic device (1) according to one of the preceding claims, **characterized in that** the mating connector part (6) is connected to the cover (2) by means of fastening elements (12), in particular screws.

21. Electronic device (1) according to one of the preceding claims, **characterized in that** the plug part (5) is connected to the housing (3) by means of fastening elements (12), in particular screws.

22. Electronic device (1) according to one of the preceding claims, **characterized in that** the plug part (5) has openings into which pins can be inserted.

23. Electronic device (1) according to one of the preceding claims, **characterized in that** the potting part (7) is connected to the potting box (9) in a materially bonded and/or form-fit manner.

24. Series of an electronic device (1), having a first variant, in which the electronic device (1) is designed according to claims 1 to 23, and a second variant, in which a plug part (5) is designed to be non-potted, **characterized in that** the first variant and the second variant have at least matching covers (2) and housings (3).

25. Series according to the preceding claim, **characterized in that** the first variant and the second variant have matching plug parts (5) and/or matching mating plug parts (6) and/or **in that** the second variant has no potting box (9).

## Revendications

1. Dispositif électronique (1), en particulier servomoteur, avec un boîtier (3) qui présente une ouverture dans laquelle est insérée une partie enfichable (5) d'une connexion électrique enfichable, **caractérisé en ce que** l'ouverture est fermable par un couvercle (2) en forme de pot qui loge une partie enfichable homologue (6) de la connexion électrique enfichable, la partie enfichable (5) étant moulée sur sa face arrière, et **en ce que** le boîtier (3) est relié de manière étanche au couvercle (2).

2. Dispositif électronique (1) selon la revendication 1, **caractérisé en ce que** la partie enfichable (5) et la partie enfichable homologue (6) sont reliées de manière détachable.

3. Dispositif électronique (1) selon l'une des revendications précédentes, **caractérisé en ce que** le couvercle (2) présente une bague d'étanchéité (4), en particulier une bague d'étanchéité de couvercle, qui a un diamètre supérieur à celui de la partie enfichable homologue (6).

4. Dispositif électronique (1) selon l'une des revendications précédentes, **caractérisé en ce que** la bague d'étanchéité (4), en particulier la bague d'étanchéité de couvercle, a un diamètre supérieur à celui de la partie enfichable (5).

5. Dispositif électronique (1) selon l'une des revendications précédentes, **caractérisé en ce que** la partie enfichable (5) est reliée côté intérieur au boîtier, de préférence directement et/ou dans une direction d'insertion de la partie enfichable (5) à distance d'une surface d'étanchéité du boîtier (3) par rapport au couvercle (2).

6. Dispositif électronique (1) selon l'une des revendications précédentes, **caractérisé en ce que** la partie enfichable (5) est reliée à une pièce de moulage (7) par engagement positif et/ou par adhérence.

7. Dispositif électronique (1) selon l'une des revendications précédentes, **caractérisé en ce que** la pièce de moulage (7) est reliée à une pièce de contre-moulage (8).

8. Dispositif électronique (1) selon l'une des revendications précédentes, **caractérisé en ce que** la pièce de contre-moulage (8) dispose d'un passage de câble (14), qui est de préférence disposé au centre du boîtier (3).

9. Dispositif électronique (1) selon l'une des revendications précédentes, **caractérisé en ce qu'**une boîte de moulage (9) est formée.

10. Dispositif électronique (1) selon l'une des revendications précédentes, **caractérisé en ce que** la boîte de moulage (9) est en contact avec la pièce de contre-moulage (8), la pièce de moulage (7) et/ou la partie enfichable (5).

11. Dispositif électronique (1) selon l'une des revendications précédentes, **caractérisé en ce que** la boîte de moulage (9) est maintenue sur la partie enfichable (5) par un mélange à mouler (13).

12. Dispositif électronique (1) selon l'une des revendications précédentes, **caractérisé en ce que** le diamètre de la boîte de moulage (9) est inférieur au diamètre de la partie enfichable (5).

13. Dispositif électronique (1) selon l'une des revendications précédentes, **caractérisé en ce que** la partie enfichable (5) est reliée au boîtier (3) au moyen d'éléments de fixation (12), en particulier de raccords par vis.

14. Dispositif électronique (1) selon l'une des revendications précédentes, **caractérisé en ce qu'**une bague d'étanchéité (10), en particulier une bague d'étanchéité de boîte de moulage, est formée entre la boîte de moulage (9) et le boîtier (3).

15. Dispositif électronique (1) selon l'une des revendications précédentes, **caractérisé en ce que** le diamètre de la bague d'étanchéité (10), en particulier de la bague d'étanchéité de la boîte de moulage, est inférieur à un diamètre maximal de la boîte de moulage (9).

16. Dispositif électronique (1) selon l'une des revendications précédentes, **caractérisé en ce que** le passage de câble (14) traverse un trou, notamment circulaire, dans la boîte de moulage (9).

17. Dispositif électronique (1) selon l'une des revendications précédentes, **caractérisé en ce qu'**un espace de fixation (11) est formé entre la partie enfichable (5) et la partie enfichable homologue (6).

18. Dispositif électronique (1) selon l'une des revendications précédentes, **caractérisé en ce que** la boîte de moulage (9) fait saillie à une extrémité directement dans l'espace de fixation (11).

19. Dispositif électronique (1) selon l'une des revendications précédentes, **caractérisé en ce que** des éléments de fixation (12), notamment des vis, font saillie dans l'espace de fixation (11).

20. Dispositif électronique (1) selon l'une des revendications précédentes, **caractérisé en ce que** la partie enfichable homologue (6) est reliée au couvercle (2) au moyen d'éléments de fixation (12), en particulier de vis.

21. Dispositif électronique (1) selon l'une des revendications précédentes, **caractérisé en ce que** la partie enfichable (5) est reliée au boîtier (3) au moyen d'éléments de fixation (12), en particulier de vis.

22. Dispositif électronique (1) selon l'une des revendications précédentes, **caractérisé en ce que** la partie enfichable (5) dispose d'ouvertures dans lesquelles des broches sont insérables.

23. Dispositif électronique (1) selon l'une des revendications précédentes, **caractérisé en ce que** la pièce de moulage (7) est reliée à la boîte de moulage (9) par une liaison de matière et/ou par engagement positif.

24. Série de produits d'un dispositif électronique (1), avec une première variante, dans laquelle le dispositif électronique (1) est réalisé selon les revendications 1 à 23, et une deuxième variante, dans laquelle une partie enfichable (5) est réalisée de manière non moulée, **caractérisée en ce que** la première variante et la deuxième variante ont au moins des couvercles (2) et des boîtiers (3) correspondants.

25. Série de produits selon la revendication précédente, **caractérisée en ce que** la première variante et la deuxième variante ont des parties enfichables (5) correspondantes et/ou des parties enfichables homologues (6) correspondantes et/ou **en ce que** la deuxième variante n'a pas de boîte de moulage (9).
